# EUROPÄISCHE PATENTSCHRIFT

(11) **EP 0 349 933 B1**
(45) Veröffentlichungstag und Bekanntmachung des Hinweises auf die Patenterteilung: **06.09.1995**
(21) Anmeldenummer: 89112031.3
(22) Anmeldetag: 01.07.1989
(51) Int. Cl.: H01L 31/024, F25D 19/00

(54) **Gehäuse für infrarotempfindliche Bauelemente**
Housing for infrared sensitive elements
Boîtier pour composants sensibles à l'infrarouge

(30) Priorität: 07.07.1988 DE 3823006
(43) Veröffentlichungstag der Anmeldung: 10.01.1990
(73) Patentinhaber: Licentia Patent-Verwaltungs-GmbH, 60596 Frankfurt (DE)
(72) Erfinder: Maier, Horst, Dr., D-7100 Heilbronn (DE); Pähler, Gottfried, Dr., D-7100 Heilbronn (DE)
(74) Vertreter: Maute, Hans-Jürgen, Dipl.-Ing.

(56) Entgegenhaltungen:
- EP-A- 0 234 644
- EP-A- 0 258 093
- GB-A- 1 168 997
- GB-A- 2 147 739
- GB-A- 2 148 051
- US-A- 4 488 414

## Beschreibung

Die Erfindung betrifft ein Gehäuse für infrarotempfindliche Bauelemente nach dem Oberbegriff des Anspruchs 1. Ein derartiges Gehäuse ist aus der GB-A-1 168 997 bekannt.

Viele optoelektronische Bauelemente, insbesondere infrarot(IR)-empfindliche Bauelemente, müssen zum Erreichen ihrer Betriebstemperatur bzw. zur Reduzierung des thermischen Rauschens auf Temperaturen weit unterhalb der Umgebungstemperatur gekühlt und zur Wärmeisolation gegenüber der Umgebung in ein Dewar-Gehäuse eingebracht werden. Die Abkühlung des Bauelements zum Erreichen seiner Betriebstemperatur soll oftmals sehr schnell (bsp. in weniger als 2s) erfolgen, während die Kühlwirkung und somit die Betriebsfähigkeit des Bauelements nur eine begrenzte Zeit zu bestehen braucht. Zu solchen Zwecken werden (neben Stirling- oder Peltier-Kühlern) in der Regel Joule-Thomson-Kühler eingesetzt, bei denen durch adiabatische Expansion eines auf 100-300 bar komprimierten Gases eine Temperaturabsenkung des Gases erreicht wird. Mit Hilfe des Gegenströmerprinzips wird in einem Wärmeaustauscherrohr des Joule-Thomson-Kühlers, welches zwei Medien mit unterschiedlicher Temperatur trennt, das aus einem Hochdruckgasspeicher oder einem Kompressor einströmende hochverdichtete Gas vor seiner Expansion durch das rückströmende entspannte Gas vorgekühlt. Durch kombinierte Anwendung der Prozeßschritte - Temperaturabsenkung mittels adiabatischer Expansion und Vorkühlung des komprimierten Gases im Wärmetauscher - kann eine Verflüssigung des Kühlmediums, z. B. Stickstoff- oder Argon-Gas, erreicht werden. Die Betriebstemperatur des Bauelements entspricht dann jeweils der Verflüssigungstemperatur des verwendeten Kühlmediums.

In der DE-A- 33 37 194 ist ein konventioneller und aus mehreren Einzelkomponenten bestehende komplexer Joule-Thomson-Kühler eng anliegend in das Gehäuse-Unterteil eines vollständig trennbaren Gehäuses eingebracht; das Gehäuse-Unterteil wird nach der Montage des Joule-Thomson-Kühlers durch Verschrauben mit einem Gehäuse-Mittelteil, einem Gehäuse-Oberteil und einer Bodenplatte als weiterem Gehäuseteil verbunden. Das zu kühlende IR-empfindliche Bauelement ist - zusammen mit dem Elementträger - im Gehäuse-Oberteil nahe der Stirnseite des Joule-Thomson-Kühlers auf Höhe der Expansionsdüse angeordnet, da dort die Temperatur am niedrigsten und somit die Kühlwirkung am effektivsten ist. Das Wärmetauscherrohr des Joule-Thomson-Kühlers ist spiralförmig auf einen zylindrischen oder konischen metallischen Trägerkörper gewickelt und wird anschließend aufgelötet; damit eine gute Kühlwirkung gewährleistet ist, muß der Joule-Thomson-Kühler eine gute Wärmeisolation vom kalten zum warmen Ende sowohl in radialer Richtung als auch längs des Trägerkörpers aufweisen - zu diesem Zweck wird der metallische Trägerkörper des Wärmetauscherrohrs wegen der guten Wärmeleitfähigkeit des Metalls sehr dünnwandig ausgebildet. Nachteilig herbei ist, daß wegen der geringen Festigkeit des dünnwandigen metallischen Trägerkörpers Stabilitätsprobleme entstehen, und daß wegen des komplexen Aufbaus von Gehäuse und Joule-Thomson-Kühler - der Trägerkörper muß als Formteil galvanisch abgeschieden werden, das Wärmetauscherrohr erst auf den Trägerkörper gewickelt und dann verlötet werden und der Joule-Thomson-Kühler in ein sehr exakt anzupassendes Gehäuse eingebracht werden - ein hoher Fertigungs-/Herstellungsaufwand und damit Kostenaufwand gegeben ist.
In der GB-A-1 168 997 ist ein gattungsgemäßes Gehäuse beschrieben, bei dem im Zwischenraum zwischen Gehäuse-Mittelteil und Gehäuse-Unterteil radiale Gasströmungs-Deflektoren angeordnet sind, die in die Zwischenräume zwischen die einzelnen Windungen des Wärmetauscherrohrs eingreifen.

Der Erfindung liegt die Aufgabe zugrunde, ein Gehäuse gemäß dem Oberbegriff des Anspruchs 1 anzugeben, bei dem die genannten Nachteile vermieden werden und das demgegenüber vorteilhafte Eigenschaften aufweist - insbesondere gute und schnelle Kühlwirkung des Joule-Thomson-Kühlers, kompakter Aufbau des Gehäuses, verbunden mit einer hohen mechanischen Stabilität des Gehäuses und einer Reduzierung des Fertigungsaufwands und Kostenaufwands.
Diese Aufgabe wird erfindungsgemäß durch die Merkmale im Kennzeichen des Patentanspruchs 1 gelöst.
Vorteilhafte Ausgestaltungen und Weiterbildungen des Gehäuses ergeben sich aus den Unteransprüchen.

Wegen der schlechten Wärmeleitfähigkeit-Eigenschaften von Gehäuse-Mittelteil und Gehäuse-Unterteil, die das Wärmetauscherrohr einschließen, können diese Gehäuseteile dickwandig und damit stabil ausgebildet werden; die Wärmeleitung in radialer Richtung wird vorzugsweise durch eine Verrippung dieser Gehäuseteile zusätzlich verringert. Gehäuse-Mittelteil und Gehäuse-Unterteil bestehen vorzugsweise aus Kunststoff-Materialien mit schlechter Wärmeleitfähigkeit, beispielsweise Polyimid oder Polyphenylensulfid; diese Kunststoff-Gehäuseteile können wegen ihrer einfachen Bauform in einer Serienproduktion als Spritzgußteile hergestellt werden, was die Fertigung erheblich vereinfacht.
Durch die flache, planare Anordnung des Wärmetauscherrohrs und dadurch, daß das Gehäuse und der Joule-Thomson-Kühler eine Einheit bilden und die Einzelteile des Gehäuses fest miteinander verbunden werden (vorzugsweise verschraubt), wird die Stabilität gegenüber Drücken und äußeren Einflüssen wie Schock, Vibrationen und Temperaturschwankungen zusätzlich erhöht. Durch die kompakte Bauweise des Gehäuses wird die Betriebstemperatur des zu kühlenden IR-empfindlichen Bauelements in weniger als 1 s erreicht. Wegen der schlechten Wärmeleitfähigkeit von Gehäuse-Mittelteil und Gehäuse-Unterteil und der hohen Wärmeleitung und Wärmekapazität des Gehäuse-Oberteils ist für den Kurzzeitbetrieb kein Isoliervakuum erforderlich. Bei längeren Betriebszeiten, z. B. länger als 5 min., kann der das IR-empfindliche Bauelement umgebende Elementraum evakuiert werden.

Die Funktionsweise eines Joule-Thomson-Kühlers und dessen bevorzugte Ausgestaltung und Integrierung in das Gehäuse für ein IRempfindliches Bauelement, beispielsweise einen IR-Sensor, soll nachstehend anhand der Figuren 1 bis 3 erläutert werden.
Hierbei zeigen: die Figur 1 im Längsschnitt den schematischen Aufbau eines Joule-Thomson-Kühlers in einem Gehäuse nach dem Stand der Technik, die Figur 2 eine Explosionsdarstellung des erfindungsgemäßen Gehäuses für ein IR-empfindliches Bauelement mit integriertem Joule-Thomson-Kühler und die Figur 3 einen Längsschnitt durch das zusammengesetzte Gehäuse.

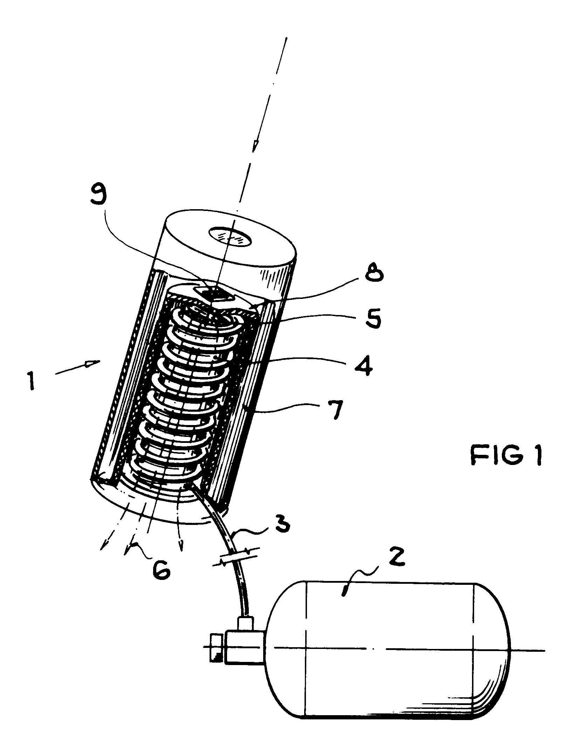

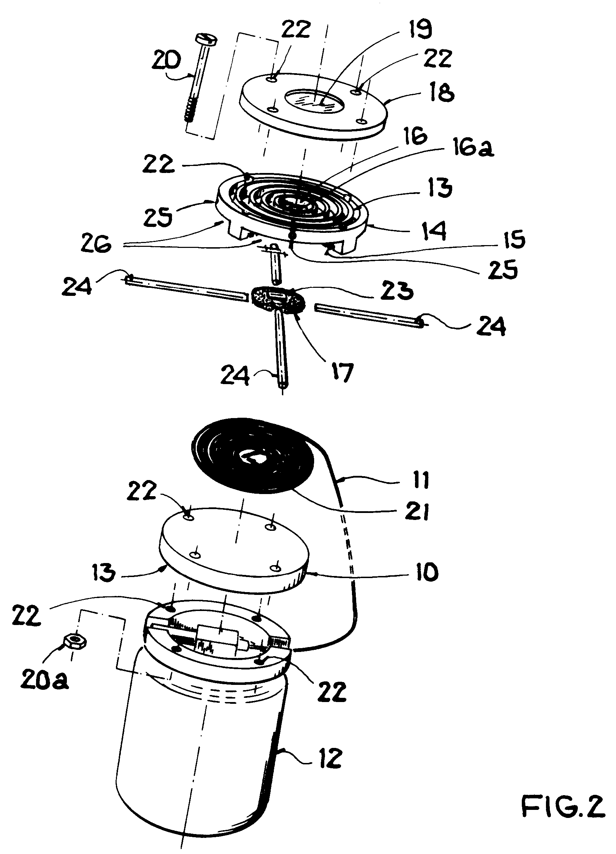

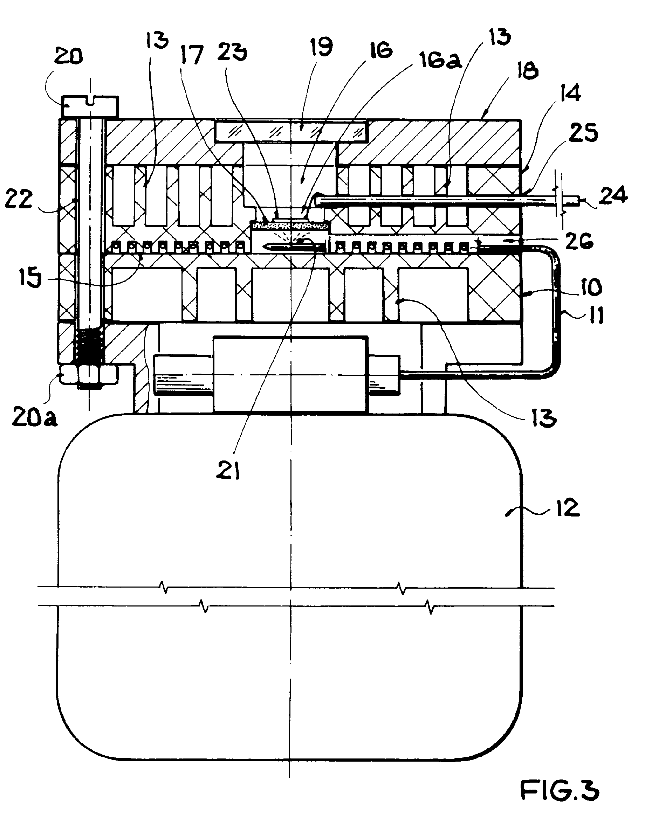

In Figur 1 ist ein Joule-Thomson-Kühler 1 mit offenem Kreislauf beschrieben, bei dem das komprimierte Kühlmedium aus einem Hochdruck-Gasspeicher 2 in das Wärmetauscherrohr 3 einströmt, welches spiralförmig um einen metallischen zylindrischen Trägerkörper 4 gewunden ist. Nach Durchlaufen des Wärmetauscherrohrs 3 entspannt sich das warme Gas in einer Expansionsdüse 5 adiabatisch, was zu einer gasart- und druckabhängigen Abkühlung des Arbeitsgases führt. Das kalte Gas 6 läuft an der Außenseite des Wärmetauscherrohrs 3 nach unten und kühlt somit das einströmende verdichtete warme Gas vor, bevor es aus dem Kühler 1 in die Umgebung austritt. Ein Isoliervakuum bzw. Isolierschild 7 dient zur Wärmeisolation gegenüber der Umgebung. Das zu kühlende Objekt ist oft als Kühlfinger 8 ausgebildet, das beispielsweise einen Detektor 9 nahe der Stirnseite des Joule-Thomson-Kühlers kühlt.
Gemäß der Explosionsdarstellung in der Figur 2 und der Schnittzeichnung des zusammengesetzten Gehäuses in der Figur 3 ist das Gehäuse für das optoelektronische Bauelement aus den drei folgenden, miteinander verschraubten, Gehäuseteilen zusammengesetzt:
- dem Gehäuse-Unterteil 10, das vorzugsweise aus Kunststoff besteht und als Begrenzungswand für das Wärmetauscherrohr 11 und für das rückströmende entspannte Gas dient. Wegen der geringen Wärmeleitfähigkeit des verwendeten Kunststoff-Materials, beispielsweise Polyimid, ist eine ausgezeichnete Wärmeisolation gegenüber der Umgebung und dem metallischen Gasvorratsbehälter 12, der als Trägerkörper für das Gehäuse ausgebildet werden kann, gegeben. Zur Erhöhung der Isolationswirkung sind, wie in der Fig. 3 ersichtlich, an der Unterseite des Gehäuse-Unterteils 10 Rippen 13 in Form konzentrischer Kreise angebracht.
- dem Gehäuse-Mittelteil 14, das aus dem gleichen Material wie das Gehäuse-Unterteil 10 besteht und das an seiner Unterseite Stege 15 aufweist, in denen das Wärmetauscherrohr 11 geführt und gehaltert wird. Die Oberseite des Gehäuse-Mittelteils 14 ist ebenso wie die Unterseite des Gehäuse-Unterteils 10 mit Rippen 13 versehen. In eine runde Aussparung 16 in der Mitte des Gehäuse-Mittelteils 14 wird der Elementträger 17 für das IR-empfindliche Bauelement eingebracht.
- dem Gehäuse-Oberteil 18, das als dünne Metallplatte ausgebildet ist, in die das Eintrittsfenster 19 für die zu detektierende IR-Strahlung eingebunden ist. Wegen der guten Wärmeleitfähigkeit und der thermischen Masse des Metalls wird ein vorzeitiges Beschlagen des Eintrittsfensters 19 vermieden. Das Eintrittsfenster 19 muß für die zu detektierende IR-Strahlung transparent sein; im infraroten Spektralbereich wird beispielsweise ein Ge-Eintrittsfenster verwendet.
- die drei Gehäuseteile 10, 14, 18 können an dem Gasvorratsbehälter 12, beispielsweise mittels Schrauben 20 und Muttern 20a, befestigt werden; hierzu sind in den drei Gehäuseteilen 10, 14, 18 und im Gasvorratsbehälter 12 Schraubenöffnungen 22 vorgesehen.

Der Joule-Thomson-Kühler gemäß Fig. 2 und 3 hat einen offenen Kreislauf; je nach Größe des Gasvorratsbehälters 12 ist eine Betriebsdauer von 30-60 s möglich. Das Wärmetauscherrohr 11 besteht aus einem Edelstahlrohr, das für Drücke bis zu 1000 bar zugelassen ist. Zur Vergrößerung der wirksamen Oberfläche werden dem Wärmetauscherrohr 11 (in Fig. 2 und 3 nicht dargestellte) metallische Rippen aufgelötet, die aus einem Metall mit guter Wärmeleitung und geringer Wärmekapazität, vorzugsweise Molybdän, bestehen. Das komprimierte Gas wird an einer Kapillare 21 am Ende des Wärmetauscherrohrs 11 entspannt und strömt - nach Vorkühlung des einströmenden Gases - durch Aussparungen 26 im Gehäuse-Mittelteil 14 radial nach außen. Der Elementraum 16a, der den Elementträger 17 und das auf diesem Träger 17 angebrachte IR-empfindliche Halbleiterbauelement 23 enthält, ist nach oben durch das metallische Gehäuse-Oberteil 18, zur Seite hin durch das Gehäuse-Mittelteil 14 aus Kunststoff und nach unten durch den metallischen Elementträger 17 hermetisch abgedichtet. Der Elementraum 16a kann zusätzlich evakuiert werden, was für kurze Betriebszeiten wegen des geringen kondensierbaren Gasvolumens jedoch nicht erforderlich ist. Das IRempfindliche Halbleiterbauelement 23 ist meist ein ternäres Halbleiterbauelement, vorzugsweise auf HgCdTe-Basis. Der Elementträger 17 besteht aus einem Stoff mit guter Wärmeleitfähigkeit, beispielsweise Molybdän oder Silizium, und wird in die Aussparung 16 des Gehäuse-Mittelteils 14 entweder eingeklebt oder, nachdem der Kunststoff an den Kontaktflächen metallisiert wurde, eingelötet. An seiner Unterseite wird der Elementträger 17 durch das kalte Gas gekühlt. Die Leiterbahn-Zuführungen 24 zur Kontaktierung des Bauelements werden radial nach außen durch den Kunststoff durchgeführt und in Bohrungen 25 des Gehäuse-Mittelteils 14 eingeklebt oder in die vorher metallisierten Kontaktflächen im Kunststoff eingelötet.
In einem Ausführungsbeispiel besitzt das 3-teilige Gehäuse aus Gehäuse-Oberteil, Gehäuse-Mittelteil und Gehäuse-Unterteil eine Gesamthöhe von 15 mm und einen Durchmesser von 35 mm; am Gehäuse-Unterteil sind 4 Rippen, und am Gehäuse-Mittelteil 5 Rippen in Form konzentrischer Kreise angeordnet. Das Wärmetauscherrohr aus Edelstahl beschreibt 10 Windungen; zu seiner Führung sind 4 Stege im Gehäuse-Mittelteil angebracht. Das Wärmetauscherrohr besitzt einen inneren Durchmesser von 0,35 mm und einen äußeren Durchmesser von 0,55 mm; an seiner Außenseite sind Rippen aus Molybdän aufgelötet, die eine Höhe von ca. 2 mm und einen seitlichen Abstand von ca. 0,2 mm besitzen. Das komprimierte Gas entspannt sich in einer Kapillare am Ende der innersten Windung des Rohres; diese Kapillare ist als 0,1 mm-Bohrung an der Seite des Rohrs ausgebildet. Das Detektorelement, ein HgCdTe-Halbleiterbauelement, ist auf einem Elementträger aus Silizium in einer Aussparung in der Mitte des Gehäuse-Mittelteils angeordnet, die einen Durchmesser von 6 mm besitzt. Der Elementträger hat eine Fläche von ca. 30 mm², das Detektorelement eine Fläche von ca. 5 mm². Der Gasvorrat hat ein Volumen von beispielsweise 20 cm³ und ist in einem Hochdruckbehälter aus Edelstahl enthalten, der mit dem Gehäuse über 4 Schrauben fest verbunden wird. Mit der vorgestellten Ausführungsform wird die Betriebstemperatur des Detektorelements in weniger als 1 s erreicht und eine Betriebsdauer von ca. 20 s ermöglicht.

Die angegebenen Ausführungsformen und die entsprechenden Abmessungen bzw. Daten können in vielfältiger Weise variiert werden: es sind kleinere oder größere integrierte Gehäuse-Kühler-Anordnungen herstellbar, ebenso Anordnungen mit längerer oder unbegrenzter Betriebszeit, mit Kompressoren anstatt Gasvorratsbehältern und mit Rückgewinnung des austretenden Kühlgases. Wegen ihres einfachen Funktionsprinzips und einfachen Aufbaus sowie ihrer geringen Störanfälligkeit können die beschriebenen Gehäuse mit integriertem Joule-Thomson-Kühler vielfältig eingesetzt werden: insbesondere sind solche Anwendungen möglich, die extrem hohe Umweltbelastungen, wie Schock, Vibration usw., beinhalten. Die zu kühlenden infrarotempfindlichen Bauelemente können dabei sowohl Einzelelemente als auch mehrelementige Detektorarrays sein. Die Signalverarbeitung durch Vorverstärker oder Multiplexer kann extern oder innerhalb der integrierten Gehäuse-Kühler-Anordnung erfolgen.

## Patentansprüche

1. Gehäuse für infrarotempfindliche Bauelemente, mit einem für den Strahlungseintritt vorgesehenen Gehäuse-Oberteil (18), einem Gehäuse-Mittelteil (14) und einem Gehäuse-Unterteil (10), wobei
a) zwischen Gehäuse-Mittelteil (14) und Gehäuse-Unterteil (10) ein spiralförmig in einer Ebene ausgebildetes Wärmetauscherrohr (11) eines Joule-Thomson-Kühlers eingeschlossen ist,
b) das Gehäuse-Mittelteil (14) und das Gehäuse-Unterteil (10) aus einem Material mit geringer Wärmeleitfähigkeit bestehen,
gekennzeichnet dadurch:
das Gehäuse-Mittelteil (14) ist als Trägerkörper derart ausgebildet, daß
c) an der Unterseite des Gehäuse-Mittelteils (14) radiale Stege (15) vorgesehen sind, die in Umfangsrichtung verlaufende Aussparungen aufweisen, in denen die einzelnen Windungen des spiralförmigen Wärmetauscherrohrs (11) geführt und gehaltert sind,
d) an der Oberseite des Gehäuse-Mittelteils (14) eine zentrisch angebrachte Aussparung (16) vorgesehen ist, in der der gekühlte Elementträger (17) für das infrarotempfindliche Bauelement (23) angeordnet ist,
e) im Gehäuse-Mittelteil (14) Bohrungen (25) vorgesehen sind, durch die die Leiterbahnzuführungen (24) für das infrarotempfindliche Bauelement (23) radial nach außen durchgeführt sind, wobei die Leiterbahnzuführungen (24) in den Bohrungen (25) verklebt oder verlötet sind.

2. Gehäuse nach Anspruch 1, dadurch gekennzeichnet, daß an der Außenseite des Wärmetauscherrohrs (11) metallische Rippen angebracht sind.

3. Gehäuse nach Anspruch 2, dadurch gekennzeichnet, daß die Rippen aus einem Metall mit hoher Wärmeleitung und geringer Wärmekapazität bestehen.

4. Gehäuse nach Anspruch 3, dadurch gekennzeichnet, daß die metallischen Rippen aus Molybdän bestehen.

5. Gehäuse nach einem der vorangehenden Ansprüche, dadurch gekennzeichnet, daß die Gehäuseteile (10, 14, 18) fest und hermetisch abgeschlossen miteinander verbunden sind.

6. Gehäuse nach einem der vorangehenden Ansprüche, dadurch gekennzeichnet, daß das Gehäuse-Mittelteil (14) und das Gehäuse-Unterteil (10) aus Kunststoff bestehen.

7. Gehäuse nach Anspruch 6, dadurch gekennzeichnet, daß als Kunststoff-Materialien Polyimid oder Polyphenylensulfid vorgesehen sind.

8. Gehäuse nach einem der vorangehenden Ansprüche, dadurch gekennzeichnet, daß an der Außenfläche des Gehäuse-Mittelteils (14) und des Gehäuse-Unterteils (10) konzentrisch verlaufende Rippen (13) zur Verbesserung der radialen Wärmeisolation angebracht sind.

9. Gehäuse nach einem der vorangehenden Ansprüche, dadurch gekennzeichnet, daß der gekühlte Elementträger (17) für das infrarotempfindliche Bauelement (23) aus einem Material mit guter Wärmeleitfähigkeit besteht.

10. Gehäuse nach Anspruch 9, dadurch gekennzeichnet, daß der Elementträger (17) aus Molybdän und Silizium besteht.

11. Gehäuse nach einem der vorangehenden Ansprüche, dadurch gekennzeichnet, daß der das infrarotempfindliche Bauelement (23) umgebende Elementraum (16a) evakuierbar ist.

12. Gehäuse nach einem der vorangehenden Ansprüche, dadurch gekennzeichnet, daß das Gehäuse-Oberteil (18) aus Metall besteht und ein Eintrittsfenster (19) für die zu detektierende Strahlung enthält.

13. Verwendung eines Gehäuses nach einem der vorangehenden Ansprüche zur Kühlung von infrarotempfindlichen Bauelementen auf HgCdTe-Basis.

14. Verwendung eines Gehäuses nach einem der vorangehenden Ansprüche zur Kühlung von infrarotempfindlichen Bauelementen mit Stickstoff, Luft, Argon, Freon oder Mischungen dieser Gase oder sequentieller Anwendung dieser Gase.

## Claims

1. Housing for infrared-sensitive components, with a top housing part (18), which is provided to admit radiation, a central housing part (14) and a bottom housing part (10), wherein
a) a heat exchanger tube (11), which is formed in a spiral shape in one plane, of a Joule-Thomson cooler is enclosed between the central housing part (14) and the bottom housing part (10),
b) the central housing part (14) and the bottom housing part (10) consist of a material of a low thermal conductivity,
characterised in that:
the central housing part (14) is formed as a carrier body such that
c) radial webs (15) are provided at the underside of the central housing part (14), which webs comprise recesses which extend in the circumferential direction and in which the individual turns of the spiral heat exchanger tube (11) are guided and held,
d) a central recess (16) is provided in the top side of the central housing part (14), in which recess the cooled component carrier (17) for the infrared-sensitive component (23) is arranged,
e) bores (25) are provided in the central housing part (14), through which bores the conductor leads (24) for the infrared-sensitive component (23) are passed radially outwards, the conductor leads (24) being glued or soldered in the bores (25).

2. Housing according to claim 1, characterised in that metallic ribs are attached to the outside of the heat exchanger tube (11).

3. Housing according to claim 2, characterised in that the ribs consist of a metal of a high thermal conductivity and a low thermal capacity.

4. Housing according to claim 3, characterised in that the metallic ribs consist of molybdenum.

5. Housing according to any one of the preceding claims, characterised in that the housing parts (10, 14, 18) are connected together in a firm and hermetically sealed manner.

6. Housing according to any one of the preceding claims, characterised in that the central housing part (14) and the bottom housing part (10) consist of plastic.

7. Housing according to claim 6, characterised in that polyimide or polyphenylene sulphide are provided as plastic materials.

8. Housing according to any one of the preceding claims, characterised in that concentrically extending ribs (13) are attached to the outer surface of the central housing part (14) and the bottom housing part (10) to improve the radial thermal insulation.

9. Housing according to any one of the preceding claims, characterised in that the cooled component carrier (17) for the infrared-sensitive component (23) consists of a material of a high thermal conductivity.

10. Housing according to claim 9, characterised in that the component carrier (17) consists of molybdenum and silicon.

11. Housing according to any one of the preceding claims, characterised in that the component space (16a) surrounding the infrared-sensitive component (23) can be evacuated.

12. Housing according to any one of the preceding claims, characterised in that the top housing part (18) consists of metal and comprises an admission window (19) for the radiation which is to be detected.

13. Use of a housing according to any one of the preceding claims for cooling HgCdTe-base infrared-sensitive components.

14. Use of a housing according to any one of the preceding claims for cooling infrared-sensitive components with nitrogen, air, argon, freon or mixtures of these gases or a sequential use of these gases.

## Revendications

1. Boîtier pour composants sensibles à l'infrarouge, comprenant une partie supérieure (18) prévue pour l'entrée du rayonnement, une partie centrale (14) et une partie inférieure (10) du boîtier, dans lequel
a) un tuyau échangeur de chaleur (11) d'un refroidisseur (à effet) Joule-Thomson, tuyau qui est disposé en spirale dans un plan, est enfermé entre la partie centrale (14) et la partie inférieure (10) du boîtier),
b) la partie centrale (14) et la partie inférieure (10) du boîtier sont faites d'un matériau à faible conductibilité thermique,
caractérisé en ce que la partie centrale (14) du boîtier est réalisée comme un corps porteur en ce sens que
c) des moulures radiales (15) sont prévues sur le dessous de la partie centrale (14) du boîtier, moulures qui présentent des évidements orientés dans le sens périphérique et dans lesquels les différentes spires du tuyau échangeur de chaleur (11) en forme de spirale sont guidées et maintenues,
d) un évidement (16) est ménagé au centre du dessus de la partie centrale (14) du boîtier, évidement dans lequel est placé le porte-composant (17) refroidi, destiné à porter le composant (23) sensible à l'infrarouge et
e) la partie centrale (14) du boîtier est pourvue de perçages (25) à travers desquels les connexions (24) pour le composant (23) sensible à l'infrarouge, réalisées sous forme de pistes conductives, sont sorties radialement à l'extérieur, les connexions-pistes conductives (24) étant collées ou soudées dans les perçages (25).

2. Boîtier selon la revendication 1, caractérisé en ce que des nervures métalliques sont disposées sur le côté extérieur du tuyau échangeur de chaleur (11).

3. Boîtier selon la revendication 2, caractérisé en ce que les nervures sont faites d'un métal à haute conductibilité thermique et faible capacité thermique.

4. Boîtier selon la revendication 3, caractérisé en ce que les nervures métalliques sont en molybdène.

5. Boîtier selon une des revendications précédentes, caractérisé en ce que les parties (10, 14, 18) du boîtier sont assemblées fermement et hermétiquement entre elles.

6. Boîtier selon une des revendications précédentes, caractérisé en ce que la partie centrale (14) et la partie inférieure (10) du boîtier sont en matière plastique.

7. Boîtier selon la revendication 6, caractérisé en ce que les matières plastiques utilisées sont le polyimide ou le polyphénylène sulfure.

8. Boîtier selon une des revendications précédentes, caractérisé en ce que la surface extérieure de la partie centrale (14) et de la partie inférieure (10) du boîtier porte des nervures (13) disposées concentriquement afin d'améliorer l'isolement thermique dans le sens radial.

9. Boîtier selon une des revendications précédentes, caractérisé en ce que le porte-composant (17) refroidi, destiné à porter le composant (23) sensible à l'infrarouge, est fait d'un matériau à bonne conductibilité thermique.

10. Boîtier selon la revendication 8, caractérisé en ce que le porte-composant (17) est en molybdène et silicium.

11. Boîtier selon une des revendications précédentes, caractérisé en ce que l'espace à composant (16a), entourant le composant (23) sensible à l'infrarouge, peut être évacué.

12. Boîtier selon une des revendications précédentes, caractérisé en ce que la partie supérieure (18) du boîtier est en métal et contient une fenêtre d'entrée (19) pour le rayonnement à détecter.

13. Utilisation d'un boîtier selon une des revendications précédentes pour refroidir des composants sensibles à l'infrarouge à base de HgCdTe.

14. Utilisation d'un boîtier selon une des revendications précédentes pour refroidir des composants sensibles à l'infrarouge par l'azote, l'air, l'argon, le fréon ou des mélanges de ces gaz, ou par application séquentielle de ces gaz.
